# EUROPEAN PATENT SPECIFICATION

(11) **EP 2 769 410 B1**
(45) Date of publication and mention of the grant of the patent: **01.12.2021**
(21) Application number: 12772970.5
(22) Date of filing: 18.10.2012
(51) Int. Cl.: H01L 25/07, H01L 23/051, H01L 23/48, H01L 23/62, H01L 23/492, H01L 23/00

(54) **POWER SEMICONDUCTOR MODULE AND POWER SEMICONDUCTOR MODULE ASSEMBLY WITH MULTIPLE POWER SEMICONDUCTOR MODULES**
LEISTUNGSHALBLEITERMODUL UND LEISTUNGSHALBLEITERMODULANORDNUNG MIT MEHREREN LEISTUNGSHALBLEITERMODULEN
MODULE SEMICONDUCTEUR DE PUISSANCE ET ENSEMBLE MODULE SEMICONDUCTEUR DE PUISSANCE COMPRENANT DE MULTIPLES MODULES SEMICONDUCTEURS DE PUISSANCE

(30) Priority: 21.10.2011 EP 11186101
(43) Date of publication of application: 27.08.2014
(73) Proprietor: ABB Power Grids Switzerland AG, 5400 Baden (CH)
(72) Inventor: DUGAL, Franc, 8121 Benglen (CH); TRÜSSEL, Dominik, 5620 Bremgarten (CH)
(74) Representative: Michalski Hüttermann & Partner Patentanwälte mbB
(86) International application number: PCT/EP2012/070621
(87) International publication number: WO 2013/057172

(56) References cited:
- EP-A1- 1 263 045
- EP-A1- 1 475 832
- DE-A1- 19 530 264
- FR-A1- 2 813 440
- JP-A- 9 275 186
- US-A- 4 950 554

## Description

### Technical Field

The present invention relates to a power semiconductor module comprising an electrically conducting base plate, an electrically conducting top plate, arranged in parallel to the base plate and spaced apart from the base plate, at least one power semiconductor device, which is arranged on the base plate in a space formed between the base plate and the top plate, and at least one presspin, which is arranged in the space formed between the base plate and the top plate to provide contact between the power semiconductor device and the top plate. The present invention further relates to a power semiconductor module assembly comprising multiple power semiconductor modules.

### Background Art

Power semiconductors devices may deal with voltages of about 1.7 kV or higher. The semiconductor device and the base plate, which is usually made of molybdenum or an alloy based on molybdenum, are in surface contact to allow conduction of electricity and heat transfer away from the semiconductor, i.e. the semiconductor device is thermally and electrically coupled to the base plate. Typical power semiconductor devices used in this area are power transistors like insulated gate bipolar transistors (IGBT), reverse conducting insulated gate bipolar transistors (reverse conducting IGBT), bi-mode insulated gate transistors (BIGT) or (power) diodes.

Power semiconductor devices are frequently combined for forming power semiconductor modules, which can deal with currents of up to 100 A or more. The power semiconductor devices are arranged in parallel on a common base plate, which usually forms an electrically conducting base of the power semiconductor module. The power semiconductor module is usually covered by an electrically conducting top plate, which is usually a lid of a housing of the power semiconductor module. The top plate provides a further contact for the power semiconductor devices. The power semiconductor modules can comprise identical power semiconductor devices, e.g. power transistors, or different power semiconductor devices, e.g. a set of power transistors and at least one power diode. The power semiconductor devices are usually connected to the electrically conducting top plate by means of the presspins. In case of power transistors used in the power semiconductor modules, also the control contacts are connected to the lid by means of presspins, whereby the top plate is electrically isolated from the control contacts. Such power modules are known from EP1475832 and EP1263045.

Multiple power semiconductor modules can further be combined to form a power semiconductor module assembly. The power semiconductor modules are arranged mechanically and electrically in parallel to each other in a common housing. The base plates of the power semiconductor modules form an electrically conducting base of the power semiconductor module assembly. Additionally, the housing of the power semiconductor module assembly is also covered by an electrically conducting lid, which is in contact with the lids of the power semiconductor modules arranged therein. In another embodiment of the power semiconductor module assembly the lid of the assembly is a common lid for the multiple power semiconductor modules therein. The power semiconductor module assembly can comprise identical power semiconductor modules, e.g. power semiconductor modules comprising power transistors and power diodes as described above, or different power semiconductor modules, e.g. a set of power semiconductor modules comprising power transistors and at least one power semiconductor module comprising power diodes. Such power semiconductor module assemblies are e.g. known as "Stakpak" from the applicant and can be used for forming stacked arrangements as used for example in HVDC applications, which deal with up to several hundred kV. Accordingly, the mechanical design of the power semiconductor module assembly is optimized in order to facilitate clamping in long stacks. In these stacked arrangements, mechanical and electrical stability of a single power semiconductor module assembly is essential to prevent failures of the entire stacked arrangement.

Instead of arranging the power semiconductor modules in power semiconductor module assemblies and stacking of the power semiconductor module assemblies, the power semiconductor modules can also be stacked directly.

In a stacked arrangement of power semiconductor modules or power semiconductor module assemblies, usually a cooler is provided between neighbouring power semiconductor modules or power semiconductor module assemblies. These coolers usually use water as heat transfer medium for cooling the stacked arrangements of power semiconductor modules or power semiconductor module assemblies. These coolers are very expensive to replace.

In the context of stacked arrangements, support of a short circuit failure mode (SCFM) of the individual power semiconductor devices is an essential feature. In case one of the power semiconductor devices fails, it fails by providing a short circuit to enable conduction from the base plate to the lid, which disables the power semiconductor device in SCFM. The same refers also to the power semiconductor module assemblies comprising the failing power semiconductor module. When multiple of the power semiconductor modules or the power semiconductor module assemblies are connected in series, e.g. forming the above-mentioned stacked arrangement, failure of a single power semiconductor device does not lead to a failure of the stacked arrangement as a whole.

Especially in this short circuit failure mode, very high currents of up to 2000A can flow through a single power semiconductor device and the respective press pin in contact with the failing power semiconductor device, since the short circuit bridges all parallel power semiconductor devices. To achieve a high life time of these power semiconductor devices and accordingly a high life time of the power semiconductor modules and the power semiconductor module assemblies, it is desired that the short circuit failure mode can be maintained for a year or even more. In power semiconductor module assemblies, failure of a single power semiconductor module is uncritical, since a neighbouring power semiconductor module can provide electrical connection between the two contacts of the assembly. Accordingly, internal damage of a power semiconductor module is tolerated within a power semiconductor module assembly, even when all pins of a single module are consumed due to arcing.

Arcing within the power semiconductor device can also involve the top plate or lid. A typical top plate of a power semiconductor device is made of copper, which provides a good conductivity and can be produced at reasonable costs. Since the arcs can cause temperatures high enough to melt the top plate, the top plate underlies wearing and oxidation and can be even destroyed. In a power semiconductor module assembly, when the top plate of a power semiconductor module is destroyed, also the lid of the power semiconductor module assembly can be affected by the arcing and thereby be destroyed. Accordingly, a failure of a single power semiconductor module can propagate to neighboring power semiconductor modules and cause failure of the entire power semiconductor module. Furthermore, in a stacked arrangement of power semiconductor modules or power semiconductor module assemblies, the problem can become even worse when the cooler between in contact with the top plate or the lid is affected by the arcing. When the cooler is destroyed, water leakage can occur and cause further failures. Water leakage in electrical installations is also a general safety problem, especially taking into account the high voltages and currents involved.

### Disclosure of Invention

It is an object of the present invention to provide a power semiconductor module according to claim 1 and a power semiconductor module assembly according to claim 8, which have a long life time, which are resistant to electrical arcing, which increase safety of stacked arrangements and which are available at low costs.

Advantageous embodiments are given in the dependent claims.

In particular, the present invention provides a power semiconductor module comprising an electrically conducting base plate, an electrically conducting top plate, arranged in parallel to the base plate and spaced apart from the base plate, at least one power semiconductor device, which is arranged on the base plate in a space formed between the base plate and the top plate, and at least one presspin, which is arranged in the space formed between the base plate and the top plate to provide contact between the power semiconductor device and the top plate, whereby a metallic protection plate is provided at an inner face of the top plate facing towards the base plate, whereby the material of the protection plate has a melting temperature higher than the melting temperature of the top plate and wherein the material of the protection plate is an alloy comprising molybdenum and copper.

The present invention also provides a power semiconductor module assembly, comprising multiple power semiconductor modules as specified above, whereby the power semiconductor modules are arranged side by side to each other with electric connections between adjacent power semiconductor modules.

The basic idea of the invention is to trap the electrical arcs between the base plate and the protection plate, so that the electrical arcs do not reach the top plate. Accordingly, the top plate is protected from the electrical arcs and shows an increased life time. Especially, the protection plate is protected from melting due to the high temperatures caused by arcing, so that the top plate is not subject to melting. The metal of the protection plate dissipates heat, which is further conducted by the protection plate and the top plate without affecting integrity of the top plate. The term metal also includes alloys, which have characteristics similar to metals. The top plate can be made of copper or other suitable materials, which are relatively cheap, and only the protection plate is made of a metal having an increased melting temperature compared to the top plate. The base plate is a common base plate made of molybdenum or other suitable materials, which is used for conducting heat and electricity and providing mechanical integrity of the power semiconductor module. The material of the protection plate also has a low electron emission, so that already the occurrence of electrical arcs is reduced.

In an example not forming part of the present invention but useful for understanding it, the material of the protection plate comprises molybdenum. In an embodiment of the present invention, the material of the base plate is an alloy comprising molybdenum and copper. These materials have a melting temperature higher than the melting temperature of a copper alone, which is a typical material for the top plate. Also the electron emission of such a protection plate is lower than the electron emission of a top plate made of copper. The use of alloys comprising molybdenum and copper reduces costs compared to a protection plate made of pure molybdenum.

In another example not forming part of the present invention but useful for understanding it, the material of the protection plate comprises tungsten. Tungsten has a high melting temperature and low electron emission rate compared to copper.

In yet another example not forming part of the present invention but useful for understanding it, the material of the top plate comprises aluminium or an alloy comprising aluminium.

In yet another example not forming part of the present invention but useful for understanding it, the material of the protection plate comprises nickel, chrome or an alloy thereof.

In a preferred embodiment of the present invention the the protection plate covers the surface of the top plate in the area of a head of the at least one presspin. In other words, the protection plate is provided to cover the top plate around the head of the presspin, and the head of the at least one press pin is in contact with the protection plate, which provides electrical contact with the top plate. Since arcing usually originates from the presspins, the area of the top plate around the presspin is frequently affected by arcing. Other areas of the top plate can be without coverage by the protection plate, when arcing does not occur frequently in these areas. In a power semiconductor device comprising multiple presspins, multiple individual protection plates can be provided. Preferably, a single protection plate is provided for a power semiconductor module. This simplifies mounting the power semiconductor module. Even more preferred, the protection plate extends over essentially the entire surface of the top plate to provide a uniform protection of the top plate. Nevertheless, areas of the top plate can be spared, e.g. when arcing does not occur in these areas or presspins are to be electrically isolated from each other. In accordance with the design of the top plate, also the protection plate can be provided with electrically isolated regions depending on the kind electrical contact made by the presspin. In case the power semiconductor device being a power transistor, the gate of the power transistor is contacted by a presspin, which is isolated from the protection plate and the top plate. In contrast, those presspins, which are in contact with the top side of the power transistor, i.e. the emitter or collector, usually the emitter of the power transistor, are in direct electrical contact with the protection plate or the top plate.

In a modified embodiment of the invention the protection plate is provided with at least one gap which is positioned to surround the head of the at least one presspin. Accordingly, the surface of the top plate is covered by the protection plate around the head of the presspin. In the case of power transistors being used as power semiconductor devices, the presspin can be either in contact with the gate or the emitter/collector, as described above. It is also possible, that the protection plate has gaps to surround only the head of a presspin contacting a gate contact, whereas the head of a presspin contacting the emitter/collector is in direct electrical contact with the protection plate.

In a preferred embodiment of the present invention the protection plate is provided integral with the head of the at least one presspin. Accordingly, electrical contact from the presspin to the protection plate is improved. In case of the power semiconductor devices being power transistors, only the head of the presspins in contact with the emitter/collector will be provided integral with the protection plate, to maintain electrical isolation between gate and the emitter/collector.

In a preferred embodiment of the present invention the at least one presspin has an inverse structure with its shaft fixed to its head and its foot moveable along its shaft. Accordingly, the foot is provided with an annular hole or through hole, which surrounds the shaft. The protection plate provides a common head for multiple presspins, whereby the shaft is fixed directly to the protection plate. The shaft can be fixed to the protection plate by means of any suitable connection type, e.g. soldering or others. The protection plate can also be provided with a hole for receiving an end region of the shaft. Preferably, the hole is a through hole. Furthermore, the hole and the end region of the shaft can be provided with a corresponding thread to facilitate mounting of the shaft to the protection plate. Additional soldering or other connection techniques can be used.

According to a modified embodiment of the invention, at least one power semiconductor device is an insulated gate bipolar transistor, a reverse conducting insulated gate bipolar transistor, a bi-mode insulated gate transistor, or a diode. These power semiconductor devices are suitable for being operated in high power conditions and can deal with high voltages and currents. Preferably, multiple identical power semiconductor devices are combined in a single power semiconductor module. Alternatively, an arbitrary set of power semiconductor devices from the listed power semiconductor devices is combined in a single power semiconductor module. In case of a diode, anode and cathode are referred to as a first and second contact. In case of power transistors, emitter and collector are referred to as a first and second contact and the gate as control contact.

According to a modified embodiment of the invention, the power semiconductor module comprises a housing, whereby the top plate forms a top side of the housing and provides a first contact of the power semiconductor module, the base plate forms a base of the housing and provides a second contact of the power semiconductor module. Generally speaking, the top plate provides a common first contact of the power semiconductor module for contacting the first contacts of the power semiconductor devices, and the base plate provides a second contact of the power semiconductor module for contacting the second contacts of the power semiconductor devices. The first and second contact of the power semiconductor module can be contacted by other power semiconductor modules in the case of a stacked arrangement or by respective contacts of a power semiconductor module assembly. In the case of power transistors like IGBTs, the first contact usually refers to an emitter contact, the second contact usually refers the collector contact, and the control contact refers to a gate contact. The control contact is not in electric contact with the lid of the power semiconductor module and can be contacted e.g. through a gap in the lid or by a lateral contact element of the power semiconductor module.

According to a preferred embodiment of the power semiconductor module assembly of the invention, the base plates of the power semiconductor modules are electrically connected to each other. The connection can be made by wiring or by providing a contact plate for contacting the base plates and/or the lids of the semiconductor modules.

According to a preferred embodiment of the power semiconductor module assembly of the invention, the power semiconductor module assembly comprises a housing, whereby an electrically conducting lid forms a top side of the housing and provides a first contact of the power semiconductor module assembly, which is in contact with the first contacts of the power semiconductor modules, and the base plates of the power semiconductor modules extend through a base of the housing. The first and second contacts of the power semiconductor module assembly can be contacted by other power semiconductor module assemblies in the case of a stacked arrangement. Generally speaking, the lid of the power semiconductor module assembly provides a first contact for contacting the first contacts of the power semiconductor modules and the base plates of the power semiconductor modules provide a common second contact of the power semiconductor modules. In case the power semiconductor modules have control contacts, they can also be electrically connected within the power semiconductor module assembly. The power semiconductor module assembly can have a lateral contact for contacting the connected control contacts of the power semiconductor modules, or the connected control contacts of the power semiconductor modules can be contacted through a gap in the lid. The first and second contact of the power semiconductor module assembly can be contacted by other power semiconductor module assemblies in the case of a stacked arrangement. In the case of power transistors like IGBTs, the first contact refers to an emitter contact, the second contact refers to a collector contact, and the control contact refers to a gate contact.

### Brief Description of Drawings

These and other aspects of the invention will be apparent from and elucidated with reference to the embodiments described hereinafter.

In the drawings:

- Fig. 1: shows a top view of a power semiconductor module according to the present invention with removed top plate,
- Fig.2: shows a sectional view along the line G-G of the power semiconductor module shown in Fig. 1,
- Fig. 3: shows a perspective cross-sectional view of the protection plate and press pins of the power semiconductor module of Fig. 1,

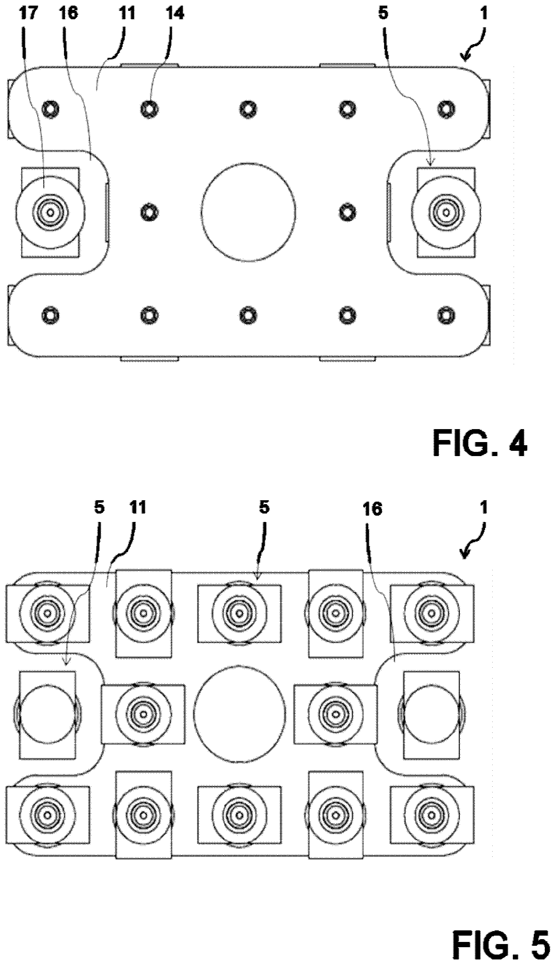

- Fig. 4: shows the top view of the power semiconductor module of Fig. 1 without its housing,
- Fig. 5: shows a bottom view of the arrangement of Fig. 4, and
- Fig. 6: shows another sectional view along the line G-G of the power semiconductor module shown in Fig. 1 with the top plate.

### Detailed Description of the Invention

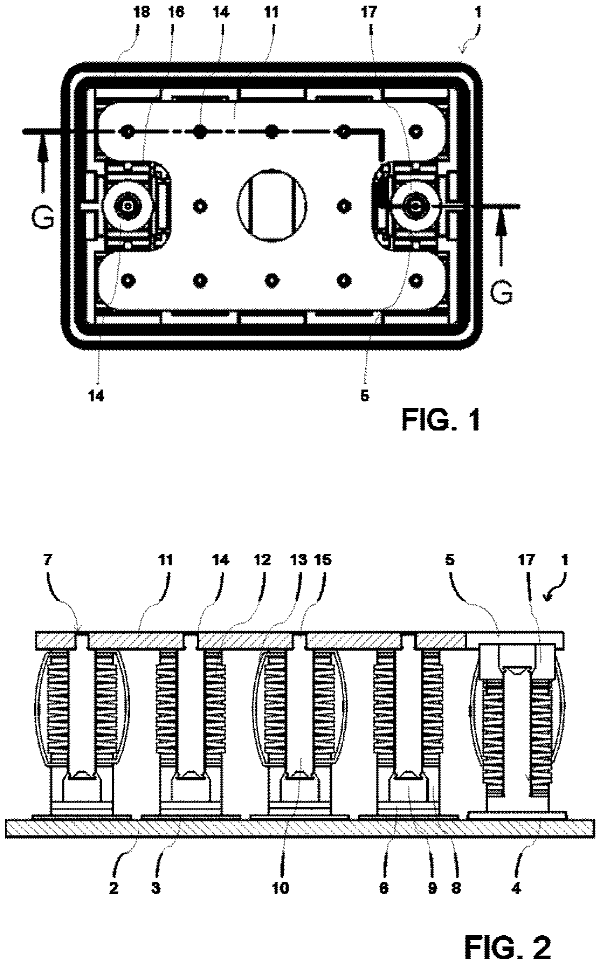

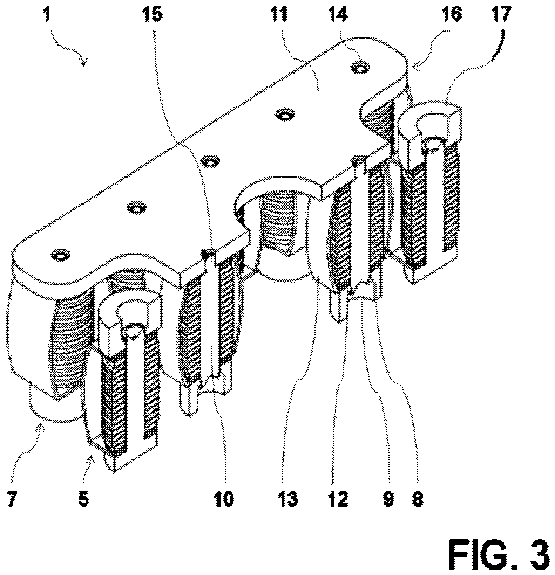

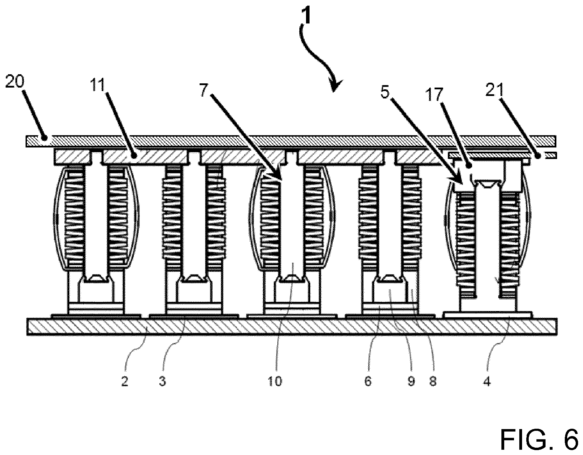

Fig. 1 shows a top view of a power semiconductor module 1 according to the present invention. The power semiconductor module 1 comprises, as best seen in Figs. 2 and 3 as well as in Fig. 6, a base plate 2 and multiple power semiconductor devices 3. The power semiconductor devices 3 in this embodiment of the invention are power transistors like IGBTs and

power diodes, which are commonly arranged on the base plate 2. The power semiconductor devices 3 are on their bottom face in surface contact with the base plate 2 to provide mechanical connection as well as electrical and thermal conductivity there between. For the IGBTs, gate runners 4 are provided on the base plate 2. Gate runners 4 are electric contact plates isolated from the base plate 2 and commonly connected to the gates of the IGBTs.

The gate runner 4 is contacted by a first presspin 5, also referred to as gate pin, which is a presspin known in the art and therefore not described in detail. The power semiconductor devices 3 are further contacted on their top face via an intermediate contact element 6, which is here shown as two-layer contact element 6, by second presspins 7, which are also referred to as chip pins. The chip pins 7 have an essentially inverse structure compared to the gate pins 5 and comprise a foot 8 with a through hole 9 and a shaft 10, which is moveable within the through hole 9. A protection plate 11 integrally forms a common head of the chip pins 7. The chip pins 7 further comprise the spring washer pack 12, which is arranged around the shaft 10 between the protection plate 11 and the foot 8 for exerting an outwardly directed force on the protection plate 11 and the foot 8, and a current bypass 13, which electrically connects the foot 8 and the protection plate 11.

For mounting the chip pins 7, the protection plate 11 is provided with several through holes 14, in which an upper end region 15 of the shaft 10 is received. The through holes 14 and the upper end regions 15 of the shafts 10 are provided with a corresponding thread, so that the shafts 10 are fixed to the protection plate 11 by means of a thread connection. In an alternative embodiment, the shafts 10 are press-fitted into the through holes 14.

In an example not forming part of the present invention but useful for understanding it, the protection plate 11 and the base plate 2 are made of molybdenum. The protection plate 11 is provided below a top plate 20, which is shown in Fig. 6, and covers the inner face of the top plate 20. The protection plate 11 is in electrical contact with the top plate 20. The protection plate 11 is provided with a number of gaps 16, which surround heads 17 of the gate pins 5. The gate pins 5 with their heads 17 are in mechanical contact with the top plate 20, whereby isolation means are provided between the head 17 and the top plate.

The power semiconductor module 1 comprises a housing 18, whereby the base plate 2 forms a base of the housing 18. The electrically conducting top plate 20 forms a top side of the housing 18. The top plate provides a first contact of the power semiconductor module 1 and the base plate 2 provides a second contact of the power semiconductor module 1. The power semiconductor devices 3 are in mechanical and electrical contact with the top plate by means of the presspins 5, 7 and, in case of the chip pins 7, the protection plate 11, whereby the gate pins 5 are electrically isolated from the top plate 20. The base plate 2 is connected to the collectors, i.e. second contacts of the power semiconductor devices 3 and forms a second contact of the power semiconductor module 1, and the emitters, i.e. first contacts of the power semiconductor devices 3 are connected to the top plate. The gates of the power semiconductor devices 3 can be commonly contacted in the power semiconductor module 1 through a gap in the top plate or be provided by a gate conductor 21 provided at the top plate 20 and insulated from it on the side towards the base plate 2.

A power semiconductor module assembly, which is not explicitly shown in the figures, comprises multiple power semiconductor modules 1 as described above. The power semiconductor modules 1 are arranged side by side to each other within a housing, whereby the base plates 2 of the power semiconductor modules 1 extend through a base of the housing. An electrically conducting lid forms a top side of the housing and provides a common contact for the power semiconductor modules 1 with electric connections between adjacent power semiconductor modules 1. The lid provides a first contact of the power semiconductor module assembly for contacting the first contacts of the power semiconductor modules 1 and the base plates 2 commonly provide a second contact of the power semiconductor module assembly. Alternatively the lid of the power semiconductor module assembly forms a common lid or a common top plate 20 for the modules arranged in the assembly. The control contacts of the power semiconductor modules 1 are connected to each other within the power semiconductor module assembly and to a lateral electric contact of the power semiconductor module assembly.

The power semiconductor modules 1 as well as the power semiconductor module assemblies can be stacked, with coolers arranged between neighboring power semiconductor modules 1 or power semiconductor module assemblies.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

**Reference signs list**
- 1: power semiconductor module
- 2: base plate
- 3: power semiconductor device
- 4: gate runner
- 5: first presspin, gate pin
- 6: contact element
- 7: second presspin, chip pin
- 8: foot
- 9: through hole
- 10: shaft
- 11: protection plate
- 12: spring washer pack
- 13: current bypass
- 14: through hole
- 15: upper end region
- 16: gap
- 17: head
- 18: housing
- 20: top plate, lid
- 21: gate conductor

## Claims

1. Power semiconductor module (1) comprising
an electrically conducting base plate (2),
an electrically conducting top plate (20), arranged in parallel to the base plate (2) and spaced apart from the base plate (2),
at least one power semiconductor device (3), which is arranged on the base plate (2) in a space formed between the base plate (2) and the top plate, and
at least one presspin (5, 7), which is arranged in the space formed between the base plate (2) and the top plate (20) to provide contact between the power semiconductor device (3) and the top plate,
**characterized in that**
a metallic protection plate (11) is provided at an inner face of the top plate facing towards the base plate (2), whereby the material of the protection plate (11) has a melting temperature higher than the melting temperature of the top plate (20), and wherein the material of the protection plate (11) is an alloy comprising molybdenum and copper.

2. Power semiconductor module (1) according to any preceding claim, **characterized in that**
the protection plate (11) covers the surface of the top plate in the area of a head (17) of the at least one presspin (7).

3. Power semiconductor module (1) according to any preceding claim 1 to 2,
**characterized in that**
the protection plate (11) is provided with at least one gap (16) which is positioned to surround a head (17) of the at least one presspin (5).

4. Power semiconductor module (1) according to any preceding claim,
**characterized in that**
the protection plate (11) is provided integral with the head of the at least one presspin (7).

5. Power semiconductor module (1) according to preceding claim 4, **characterized in that**
the least one presspin (7) has a structure with its shaft (10) fixed to its head and its foot movable (8) along its shaft (10).

6. Power semiconductor module (1) according to any preceding claim,
**characterized in that**
the at least one power semiconductor device (3) is an insulated gate bipolar transistor, a reverse conducting insulated gate bipolar transistor, a bi-mode insulated gate transistor, or a diode.

7. Power semiconductor module (1) according to any preceding claim,
**characterized in that**
the power semiconductor module (1) comprises a housing (18), whereby
the top plate forms a top side of the housing (18) and provides a first contact of the power semiconductor module (1),
the base plate (2) forms a base of the housing (18) and provides a second contact of the power semiconductor module (1).

8. Power semiconductor module assembly, comprising multiple power semiconductor modules (1) according to any of preceding claims 1 to 7, whereby
the power semiconductor modules (1) are arranged side by side to each other with electric connections between adjacent power semiconductor modules (1).

9. Power semiconductor module assembly according to preceding claim 8, **characterized in that**
the base plates (2) of the power semiconductor modules (1) are electrically connected to each other.

10. Power semiconductor module assembly according to any of preceding 8 or 9, **characterized in that**
the power semiconductor module assembly comprises a housing, whereby an electrically conducting lid forms a top side of the housing and provides a first contact of the power semiconductor module assembly, which is in contact with the first contacts of the power semiconductor modules (1), and
the base plates (2) of the power semiconductor modules (1) extend through a base of the housing.

## Patentansprüche

1. Halbleiter-Leistungsmodul (1), umfassend:
eine elektrisch leitende Bodenplatte (2),
eine elektrisch leitende obere Platte (20), die parallel zur Bodenplatte (2) angeordnet und von der Bodenplatte (2) beabstandet ist,
mindestens ein Halbleiter-Leistungsbauelement (3), das auf der Bodenplatte (2) in einem Zwischenraum angeordnet ist, der zwischen der Bodenplatte (2) und der oberen Platte gebildet ist, und
mindestens einen Pressstift (5, 7), der in dem Zwischenraum angeordnet ist, der zwischen der Bodenplatte (2) und der oberen Platte (20) gebildet ist, um Kontakt zwischen dem Halbleiter-Leistungsbauelement (3) und der oberen Platte bereitzustellen,
**dadurch gekennzeichnet, dass**
an einer Innenfläche der oberen Platte, die zu der Bodenplatte (2) weist, eine metallische Schutzplatte (11) bereitgestellt ist, wobei das Material der Schutzplatte (11) eine Schmelztemperatur aufweist, die höher als die Schmelztemperatur der oberen Platte (20) ist, und wobei das Material der Schutzplatte (11) eine Legierung ist, die Molybdän und Kupfer umfasst.

2. Halbleiter-Leistungsmodul (1) nach einem vorhergehenden Anspruch,
**dadurch gekennzeichnet, dass**
die Schutzplatte (11) die Oberfläche der oberen Platte in dem Bereich eines Kopfs (17) des mindestens einen Pressstifts (7) abdeckt.

3. Halbleiter-Leistungsmodul (1) nach einem der Ansprüche 1 bis 2,
**dadurch gekennzeichnet, dass**
die Schutzplatte (11) mit mindestens einem Spalt (16) versehen ist, der dafür positioniert ist, einen Kopf (17) des mindestens einen Pressstifts (5) zu umgeben.

4. Halbleiter-Leistungsmodul (1) nach einem vorhergehenden Anspruch,
**dadurch gekennzeichnet, dass**
die Schutzplatte (11) einstückig mit dem Kopf des mindestens einen Pressstifts (7) bereitgestellt ist.

5. Halbleiter-Leistungsmodul (1) nach dem vorhergehenden Anspruch 4,
**dadurch gekennzeichnet, dass**
der mindestens eine Pressstift (7) eine Struktur aufweist, bei der sein Schaft (10) an seinem Kopf befestigt ist und sein Fuß (8) entlang seines Schafts (10) beweglich ist.

6. Halbleiter-Leistungsmodul (1) nach einem vorhergehenden Anspruch,
**dadurch gekennzeichnet, dass**
das mindestens eine Halbleiter-Leistungsbauelement (3) ein IGBT (Insulated Gate Bipolar Transistor), ein rückwärts leitfähiger IGBT, ein BIGT (Bi-mode Insulated Gate Transistor) oder eine Diode ist.

7. Halbleiter-Leistungsmodul (1) nach einem vorhergehenden Anspruch,
**dadurch gekennzeichnet, dass**
das Halbleiter-Leistungsmodul (1) ein Gehäuse (18) umfasst, wobei
die obere Platte eine Oberseite des Gehäuses (18) bildet und einen ersten Kontakt des Halbleiter-Leistungsmoduls (1) bereitstellt,
die Bodenplatte (2) einen Boden des Gehäuses (18) bildet und einen zweiten Kontakt des Halbleiter-Leistungsmoduls (1) bereitstellt.

8. Halbleiter-Leistungsmodul-Anordnung, mehrere Halbleiter-Leistungsmodule (1) nach einem der Ansprüche 1 bis 7 umfassend,
wobei
die Halbleiter-Leistungsmodule (1) nebeneinander, mit elektrischen Verbindungen zwischen benachbarten Halbleiter-Leistungsmodulen (1) angeordnet sind.

9. Halbleiter-Leistungsmodul-Anordnung nach Anspruch 8,
**dadurch gekennzeichnet, dass**
die Bodenplatten (2) der Halbleiter-Leistungsmodule (1) miteinander elektrisch verbunden sind.

10. Halbleiter-Leistungsmodul-Anordnung nach einem der vorhergehenden 8 oder 9,
**dadurch gekennzeichnet, dass**
die Halbleiter-Leistungsmodul-Anordnung ein Gehäuse umfasst, wobei ein elektrisch leitender Deckel eine Oberseite des Gehäuses bildet und einen ersten Kontakt der Halbleiter-Leistungsmodul-Anordnung bereitstellt, der in Kontakt mit den ersten Kontakten der Halbleiter-Leistungsmodule (1) steht, und
sich die Bodenplatten (2) der Halbleiter-Leistungsmodule (1) durch einen Boden des Gehäuses erstrecken.

## Revendications

1. Module semiconducteur de puissance (1) comprenant une plaque de base électroconductrice (2),
une plaque de dessus électroconductrice (20), agencée en parallèle à la plaque de base (2) et espacée de la plaque de base (2),
au moins un dispositif semiconducteur de puissance (3), qui est agencé sur la plaque de base (2) dans un espace formé entre la plaque de base (2) et la plaque de dessus, et
au moins une cheville de presse (5, 7), qui est agencée dans l'espace formé entre la plaque de base (2) et la plaque de dessus (20) pour fournir un contact entre le dispositif semiconducteur de puissance (3) et la plaque de dessus,
**caractérisé en ce que**
une plaque de protection métallique (11) est fournie au niveau d'une face interne de la plaque de dessus faisant face à la plaque de base (2), le matériau de la plaque de protection (11) ayant une température de fusion plus élevée que la température de fusion de la plaque de dessus (20), et le matériau de la plaque de protection (11) étant un alliage comprenant du molybdène et du cuivre.

2. Module semiconducteur de puissance (1) selon l'une quelconque des revendications précédentes, **caractérisé en ce que** la plaque de protection (11) recouvre la surface de la plaque de dessus dans la zone d'une tête (17) de l'au moins une cheville de presse (7).

3. Module semiconducteur de puissance (1) selon l'une quelconque des revendications précédentes 1 et 2, **caractérisé en ce que** la plaque de protection (11) est pourvue d'au moins un espace (16) qui est positionné de façon à entourer une tête (17) de l'au moins une cheville de presse (5).

4. Module semiconducteur de puissance (1) selon l'une quelconque des revendications précédentes, **caractérisé en ce que** la plaque de protection (11) est fournie d'un seul tenant avec la tête de l'au moins une cheville de presse (7).

5. Module semiconducteur de puissance (1) selon la revendication précédente 4, **caractérisé en ce qu'**au moins une cheville de presse (7) a une structure avec son arbre (10) fixé à sa tête et son pied mobile (8) le long de son arbre (10).

6. Module semiconducteur de puissance (1) selon l'une quelconque des revendications précédentes, **caractérisé en ce que** l'au moins un dispositif semiconducteur de puissance (3) est un transistor bipolaire à porte isolée, un transistor bipolaire à porte isolée à conduction inverse, un transistor à porte isolée bimode, ou une diode.

7. Module semiconducteur de puissance (1) selon l'une quelconque des revendications précédentes, **caractérisé en ce que**
le module semiconducteur de puissance (1) comprend un logement (18),
la plaque de dessus formant un côté de dessus du logement (18) et fournissant un premier contact du module semiconducteur de puissance (1),
la plaque de base (2) formant une base du logement (18) et fournissant un deuxième contact du module semiconducteur de puissance (1).

8. Ensemble module semiconducteur de puissance, comprenant de multiples modules semiconducteurs de puissance (1) selon l'une quelconque des revendications 1 à 7, les modules semiconducteurs de puissance (1) étant agencés côte à côte avec des connexions électriques entre des modules semiconducteurs de puissance adjacents (1).

9. Ensemble module semi-conducteur de puissance selon la revendication 8, **caractérisé en ce que** les plaques de base (2) des modules semiconducteurs de puissance (1) sont électriquement connectées l'une à l'autre.

10. Ensemble de module semiconducteur de puissance selon l'une quelconque des précédentes 8 et 9, **caractérisé en ce que**
l'ensemble module semiconducteur de puissance comprend un logement, un couvercle électroconducteur formant un côté de dessus du logement et fournissant un premier contact de l'ensemble module semiconducteur de puissance, qui est en contact avec les premiers contacts des modules semiconducteurs de puissance (1), et
les plaques de base (2) des modules semiconducteurs de puissance (1) s'étendent à travers une base du logement.
